# EUROPEAN PATENT APPLICATION

(11) **EP 1 780 734 A1**
(43) Date of publication of application: **02.05.2007**
(21) Application number: 05751292.3
(22) Date of filing: 06.06.2005
(51) Int. Cl.: H01B 13/00, H01B 12/10

(54) **METHOD FOR PRODUCING SUPERCONDUCTING WIRE**

(30) Priority: 29.07.2004 JP 2004222228
(71) Applicant: Sumitomo Electric Industries, Ltd., Osaka-shi, Osaka 541 (JP)
(72) Inventor: YAMAZAKI, Kouhei c/o Osaka Works of SUMITOMO ELEC. INDUSTRIES LTD., Osaka-shi, Osaka;5548511 (JP); AYAI, Naoki c/o Osaka Works of SUMITOMO ELEC. INDUSTRIES LTD., Osaka-shi, Osaka;5548511 (JP)
(74) Representative: Kreutzer, Ulrich
(86) International application number: PCT/JP2005/010330
(87) International publication number: WO 2006/011302

(57) **Abstract**

A superconducting wire (1) includes a filament portion (2) which contains a Bi-2223 phase and a sheath portion (3) covering the filament portion. A method for producing the superconducting wire includes a filling step, a drawing step, a rolling step, and a sintering step. The filament portion is absent of the Bi-2223 phase in composition prior to the sintering step.

## Description

### Technical Field

The present invention relates to a method for producing an oxide superconducting wire, particularly a method for producing a superconducting wire formed of a filament portion including a Bi-2223 phase and a sheath portion covering the filament portion.

### Background Art

As a conventional method for producing a superconducting wire formed of a filament portion including a Bi-2223 phase and a sheath portion covering the filament portion, there is known the method including the steps of filling a metal tube with superconductor raw material powder, and then applying a sintering process on the wire obtained by subjecting the metal tube to drawing and rolling, whereby the superconductor raw material powder is sintered to obtain an oxide superconducting wire (for example, Patent Documents 1-3).

For the purpose of improving critical current (Ic) in accordance with the aforementioned method, a superconducting wire is produced by adjusting the composition of the superconductor raw material powder (Japanese Patent Laying-Open No. 04-212215 (Patent Document 2)), applying pretreatment (Japanese Patent Laying-Open No. 04-094019 (Patent Document 1)), or adjusting the heat treatment condition (Japanese Patent Laying-Open No. 2003-203532 (Patent Document 3)).

Although the superconducting wire obtained by such methods has the critical current (Ic) improved to a certain level, the need arises for further improvement of the critical current (Ic) corresponding to the extensive increase of the usage of superconductor wires.
Patent Document 1: Japanese Patent Laying-Open No. 04-094019
Patent Document 2: Japanese Patent Laying-Open No. 04-212215
Patent Document 3: Japanese Patent Laying-Open No. 2003-203532

### Disclosure of the Invention

### Problems to be Solved by the Invention

In view of the foregoing, an object of the present invention is to provide a method for producing a superconducting wire, aimed to improve critical current (Ic).

### Means for Solving the Problems

The inventors of the present invention worked diligently to solve the problem set forth above, and became aware of the importance of, in order to improve the critical current (Ic) of a superconducting wire formed of a filament portion including a Bi-2223 phase and a sheath portion covering the filament portion, achieving the basic conditions of rendering the filament portion monophase with a Bi-2223 phase and improving the orientation as well as improving the connectivity of the crystal grains by increasing the thickness of the Bi-2223 phase crystal. The inventors found that, in order to achieve these basic conditions, adjusting the composition of the filament portion prior to the sintering step is most effective. The inventors made further investigations based on this finding to achieve the present invention.

The present invention is directed to a method for producing a superconducting wire including a filament portion with a Bi-2223 phase and a sheath portion covering the filament portion. The method for producing a superconducting wire includes a filling step, a drawing step, a rolling step, and a sintering step. The filament portion is absent of a Bi-2223 phase in composition prior to the sintering step.

The Bi-2223 phase of the present invention includes bismuth, lead, strontium, calcium, copper, and oxygen, and refers to a Bi-Sr-Ca-Cu-O type oxide superconducting phase (also noted as the (Bi, Pb) 2223 phase) represented by the atomic ratio (excluding oxygen) of (bismuth and lead): strontium: calcium: copper approximating 2:2:2:3. Specifically, it includes those represented by the chemical formula of (BiPb)₂Sr₂Ca₂Cu₃O_{10+z}, where z in the formula represents the oxygen content. It is known that the critical temperature (Tc) and/or critical current (Ic) vary depending upon z.

The sintering step in the method for producing a superconducting wire of the present invention set forth above is preferably executed under the conditions of at least 0.03 atm and not more than 0.21 atm in oxygen partial pressure, at least 810°C and not more than 850°C in sintering temperature, and at least 20 hours and not more than 100 hours in the sintering duration.

With regards to the composition prior to the sintering step of the filament portion, the composition ratio of Bi and Pb is preferably at least 0.14 and not more than 0.18 corresponding to the atomic ratio represented as Pb/(Bi+Pb).

Preferably in the producing method, the sintering step is carried out at least two times, and the composition of the filament portion prior to the first sintering step among the sintering steps carried out two times or more is absent of a Bi-2223 phase.

The present invention also relates to a superconducting wire produced by the superconducting wire producing method set forth above, and a superconducting apparatus using such a superconducting wire.

### Effects of the Invention

The superconducting wire obtained by the producing method set forth above of the present invention exhibits high critical current (Ic). Therefore, the superconducting wire of the present invention can be used in the applications of, for example, cables, magnets, transformers, current leads, current limiters, power storage devices, and the like.

### Brief Description of the Drawings

Fig. 1 is a schematic partial sectional perspective view of a superconducting wire.
Fig. 2A schematically represents the state of many crystals of the Bi-2223 phase growing parallel to the longitudinal direction of the surface of the superconducting wire.
Fig. 2B schematically represents the state of many gaps between the crystals of the Bi-2223 phase due to the growth of crystals deviated in orientation with respect to the longitudinal direction of the surface of the superconducting wire.
Fig. 3 represents an exemplified method for producing a superconducting wire.

### Description of the Reference Signs

1 superconducting wire, 2 filament portion, 3 sheath portion, 4 crystal of Bi-2223 phase, 5 surface, 6 gap

### Best Modes for Carrying Out the Invention

The present invention will be described in further detail hereinafter. In the following description, embodiments will be described with reference to the drawings. In the drawings of the present application, elements with the same reference characters allotted represent the same or corresponding elements.

### <Superconducting Wire>

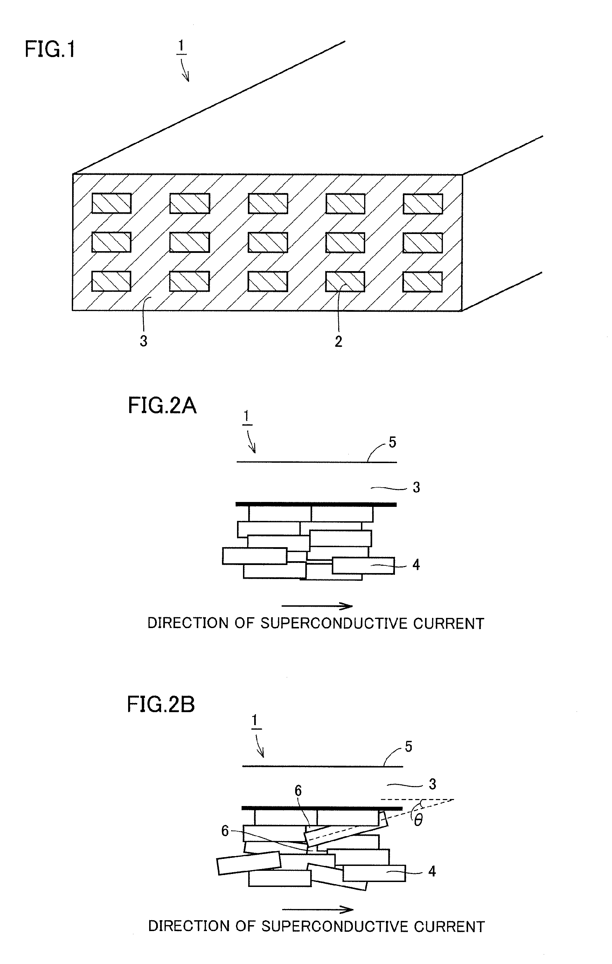

A superconducting wire of the present invention has a structure including a filament portion with a Bi-2223 phase and a sheath portion covering the filament portion. Fig. 1 is a schematic partial sectional perspective view of the structure. A superconducting wire 1 of the present invention includes a filament portion 2 with a Bi-2223 phase, extending in the longitudinal direction, and a sheath portion 3.

Since the Bi-2223 phase has the property of extremely fast crystal growth in the direction of a and b axes than the c axis as to the crystallographic axis, the Bi-2223 phase is liable to have an orientational structure formed of thin plate crystals with ab planes uniform in orientation.

Accordingly, the superconducting current flowing through the superconducting wire of the present invention will flow within and between plate crystals having uniform ab planes (the plane including the a axis and b axis) as set forth above. By achieving monophase with respect to the Bi-2223 phase, improving the orientation of plate crystals, increasing the thickness of each crystal grain, and uniting each of the crystal grains densely (improving the connectivity between the crystal grains), the superconductive property, i.e. critical current (Ic), can be improved.

Improving the orientation of plate crystals of the Bi-2223 phase implies the state in which many crystals 4 of the Bi-2223 phase grow parallel to the longitudinal direction of the surface 5 of superconducting wire 1, as indicated by the schematic diagram of Fig. 2A.

In contrast, many gaps 6 will be generated if the orientation is degraded, as shown in Fig. 2B. As a result, the superconductive current cannot flow easily, so that only a low critical current can be obtained.

An index to determine the superiority of the crystal orientation can be representing based on the orientation deviation (the angle between the ab plane of the Bi-2223 phase crystal and the longitudinal direction of the superconducting wire, i.e. angle θ in Fig. 2B). The crystal orientation becomes higher as the angle (deg) representing the orientation deviation becomes smaller. This orientation deviation can be obtained statistically by measuring a rocking curve through X-ray diffraction.

The sheath portion is also called an armour, and serves to protect and support the filament portion. The sheath portion is formed of metal or alloy. Preferably, silver, silver alloy, gold, gold alloy, and the like can be employed.

Although Fig. 1 shows a multi-filament structure in which a plurality of filament portions 2 including the Bi-2223 phase are covered with sheath portion 3, the number of filament portions is not particularly limited. A mono-filament structure in which one filament portion is covered with the sheath portion is also applicable.

The filament portion including the Bi-2223 phase as the main component may also include a slight amount of another component. For example, the Bi-2212 phase and the like can be cited as such an another component. This Bi-2212 phase includes bismuth, lead, strontium, calcium, copper, and oxygen, and refers to a Bi-Sr-Ca-Cu-O type oxide superconducting phase (also noted as the (Bi, Pb) 2212 phase) represented by the atomic ratio (excluding oxygen) of (bismuth and lead): strontium: calcium: copper approximating 2:2:1:2. Specifically, it includes those represented by the chemical formula of (BiPb)₂Sr₂Ca₁Cu₂O_{8+z}, where z in the formula represents the oxygen content. It is known that the critical temperature (Tc) and/or critical current (Ic) vary depending upon z.

The amount of such another component is preferably as small as possible since the superconducting current flowing through the filament portion will be reduced. This is the reason why a single phase of the Bi-2223 phase is desired.

The shape of the superconducting wire of the present invention takes, but not particularly limited to, a tape-like form having a cross section of substantially a rectangle, by way of example.

Specifically, a superconducting wire tape having a width of 3.5 to 5.0 mm, a thickness of 0.2 to 0.3 mm, and of a short length up to several meters as well as a superconducting wire tape having the same width and thickness, and of a long length of 100 m to several kilometers can be cited.

### <Method for Producing Superconducting Wire>

The present invention is directed to a method for producing a superconducting wire including a filament portion with a Bi-2223 phase and a sheath portion covering the filament portion. The producing method includes a filling step, a drawing step, a rolling step, and a sintering step. The filament portion does not include the Bi-2223 phase in composition prior to the sintering step. The four steps of these filling step, drawing step, rolling step, and sintering step are preferably executed in this order.

The sintering step in the method for producing a superconducting wire of the present invention is preferably executed under the conditions of at least 0.03 atm and not more than 0.21 atm in oxygen partial pressure, at least 810°C and not more than 850°C in sintering temperature, and at least 20 hours and not more than 100 hours in the sintering duration.

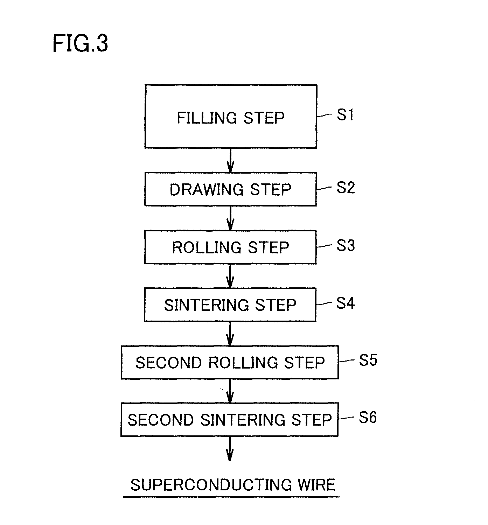

The method for producing a superconducting wire of the present invention may include another step in addition to the four steps set forth above, i.e., as long as the filling step, drawing step, rolling step, and sintering step are included. For example, the method for producing a superconducting wire of the present invention may include two or more of the rolling step and sintering step, as indicated by way of example in Fig. 3.

In the case where the sintering step is carried out two or more times, the filament portion is absent of the Bi-2223 phase prior to the initial (first) sintering step, and the filament portion includes the Bi-2223 phase subsequent to the initial (first) sintering step. The suitable condition for the sintering step set forth above applies to the initial (first) sintering step, and the condition set forth above does not necessarily have to be employed in the second sintering step onward.

The method for producing a superconducting wire of the present invention will be further described with reference to Fig. 3. In the method for producing a superconducting wire of the present invention, any conventional apparatus known for producing this type of superconducting wire can be used without particular limitation.

In the filling step (step S1), a metal tube that will constitute the sheath portion is filled with raw material powder (for example, oxide powder of each constituent metal) that will constitute the filament portion including the Bi-2223 phase. A superconducting wire of a multifilament structure or a monofilament structure can be obtained depending upon this filling method.

The raw material powder can be subjected to pretreatment such as heat treatment under the atmosphere of various oxygen partial pressure (oxygen concentration) before insertion into the metal tube.

In the drawing step (step S2), the metal tube filled with raw material powder is worked into a wire having the desired diameter and shape by drawing. Accordingly, a wire is obtained having a configuration in which the filament portion formed of the raw material powder is covered with metal.

In the next rolling step (step S3), the wire worked in the drawing step is subjected to rolling to take the desired tape-like shape.

By the sintering step (step S4) subsequent to the rolling step, a superconducting wire of the present invention is produced. Details of the sintering step (step S4) will be described afterwards.

The rolling step and sintering step can be carried out two times (steps S5-S6), as shown in Fig. 3, or more than two times. By repeating these steps, the Bi-2223 phase orientation is further improved. Additionally, the connectivity between the Bi-2223 phase crystal grains can be further improved.

### <Composition of Filament Portion Prior to Sintering>

The filament portion in the superconducting wire of the present invention is characterized in that the Bi-2223 phase is absent in composition prior to the sintering step. This absence of the Bi-2223 phase in composition prior to the sintering step allows growth of a large crystal (increased thickness) of the Bi-2223 phase with high orientation and facilitates monophase of the Bi-2223 phase at the same time in the sintering step. Thus, the basic conditions of rendering the filament portion monophase with a Bi-2223 phase and improving the orientation as well as improving the connectivity of the crystal grains by increasing the thickness of the Bi-2223 phase crystal can be achieved at the same time, directed to improving critical current (Jc) of the superconducting wire.

Although the detailed mechanism of how the superior effect set forth above is achieved by the absence of the Bi-2223 phase in composition prior to the sintering step is not yet clarified, the inventors considered that the absence of the Bi-2223 phase in the composition prior to the sintering step minimizes the number of seed crystals corresponding to the core of the Bi-2223 phase crystal growth at a stage prior to the sintering step so that mutual interference caused by the growth of the plurality of crystal grains with the seed crystals as the starting point is reduced in the sintering step, whereby Bi-2223 phase crystal growth advances sufficiently with the very few seed crystals as the starting point to result in the generation of an extremely large crystal grain with great thickness.

The filament portion in the superconducting wire of the present invention that does not include the Bi-2223 phase in composition prior to the sintering step has crystal growth of the Bi-2223 phase promoted by executing the sintering step that will be described afterwards, whereby superconductivity is exhibited.

The composition of the filament portion prior to the sintering step is not particularly limited, as long as the Bi-2223 phase is not included. The filament portion is generally formed of oxide raw material powder that will constitute the Bi-2223 phase or the aforementioned Bi-2212 phase. Absence of the Bi-2223 phase in composition in the filament portion prior to the sintering step can be determined by X-ray diffraction or a SQUID (superconducting quantum interference device) fluxmeter.

With regards to the composition of the filament portion prior to the sintering step, the Bi and Pb composition ratio is preferably at least 0.14 and not more than 0.18 corresponding to the atomic ratio represented by Pb/(Bi+Pb). This is because the (Bi, Pb) 2212 phase with Pb permeated in the Bi-2212 phase must be generated for the generation of the Bi-2223 phase (more precisely, (Bi, Pb) 2223 phase) in the sintering step. The optimum atomic ratio is at least 0.14 and not more than 0.18 for such generation. If this atomic ratio is less than 0.14, the (Bi, Pb) 2212 phase cannot be generated easily since the Pb is low, which in turn renders the generation of the (Bi, Pb) 2223 phase difficult. If the atomic ratio exceeds 0.18, the (Bi, Pb) Bi-2223 phase will be readily generated due to the large amount of Pb, but the Pb compound identified as a non-conductive layer will remain after the heat treatment to degrade the superconducting property.

The composition ratio of Bi and Pb can be determined by quantitive analysis using an ICP emission spectrophotometer.

### <Sintering Step>

In the sintering step of the present invention, heat treatment is applied to the wire subjected to the rolling step set forth above to sinter the oxide raw material powder or Bi-2212 phase included in the filament portion, whereby the Bi-2223 phase crystal is grown.

The sintering step can be executed under the conditions of at least 0.03 atm and not more than 0.21 atm in oxygen partial pressure, at least 810°C and not more than 850°C in sintering temperature, and at least 20 hours and not more 100 hours in the sintering duration.

The oxygen partial pressure is preferably set to at least 0.03 atm and not more than 0.21 atm. More preferably, the upper limit is 0.21 atm and the lower limit is 0.08 atm, and further preferably the lower limit is 0.15 atm.

The oxygen partial pressure of the range set forth above is employed because, if the oxygen partial pressure is less than 0.03 atm, the Bi-2223 phase crystal will grow so fast that a thick crystal of favorable orientation may not be obtained, and if the oxygen partial pressure exceeds 0.21 atm, the (Bi, Pb) 2212 phase will not be readily generated, which in turn renders generation of the (Bi, Pb) 2223 phase difficult.

The gas component other than oxygen in the atmosphere that presents the oxygen partial pressure set forth above is not particularly limited as long as the oxygen partial pressure of the aforementioned range is achieved. Inert gas such as nitrogen (N₂) gas, argon (Ar), or the like is preferably used.

The sintering temperature is preferably at least 810°C and not more than 850°C. The upper limit is more preferably 845°C, further preferably 840°C. The lower limit is more preferably 820°C, further preferably 830°C.

The sintering temperature of the aforementioned range is employed because, if the temperature is below 810°C, formation of the Bi-2223 phase may not advance sufficiently, and if the temperature exceeds 850°C, the interior of the filament portion may melt and also the sheath portion may melt.

Further, the sintering duration is preferably at least 20 hours and not more than 100 hours. The upper limit thereof is more preferably 80 hours, further preferably 70 hours. The lower limit thereof is more preferably 30 hours, further preferably 40 hours, and particularly preferably 50 hours.

By setting the sintering duration longer than that of the conventional case, crystal growth of the Bi-2223 phase can advance sufficiently, although at a low rate, such that crystals of further thickness can be generated densely with high orientation. If the sintering duration is less than 20 hours, crystal growth will not advance sufficiently, such that a thick crystal cannot be readily obtained. As a result, high critical current (Ic) cannot be obtained. If the sintering duration exceeds 100 hours, crystal growth will reach a level of saturation. Any further sintering is economically disadvantageous since more energy will be consumed even though further improvement of the critical current cannot be expected.

It is to be noted that the sintering duration set forth above does not include the time required to elevate to the aforementioned sintering temperature, or the time required to lower the temperature to the level required for the next step.

### <Superconductive Apparatus>

The present invention relates to a superconducting wire produced by the superconducting wire producing method set forth above, and also to a superconductive apparatus characterized by the usage of such a superconducting wire. For example, cables, magnets, transformers, current leads, current limiters, and power storage devices, can be enumerated as such a superconductive apparatus, all exhibiting superior superconducting properties. The manner of applying such a superconducting wire to a superconductive apparatus is not particularly limited, and the general application manner can be employed.

Although the present invention will be described in further detail based on examples, the present invention is not limited to such examples.

### <Examples 1-3 and Comparative Examples 1-4>

A filling step was conducted to fill a silver tube that will constitute a sheath portion with raw material powder that will constitute the Bi-2223 phase (a blend of each powder of Bi₂O₃, PbO, SrCO₃, CaCO₃, CuO mixed in the ratio of 1.81:0.4:1.98:2.20:3.01 (mass ratio)) in order to have the silver ratio of 1.5 and include 55 filaments with the Bi-2223 phase.

The silver ratio refers to the ratio of the total area of the sheath portion formed of silver to the total area of the filament portion at a cross section of the wire prior to the sintering step.

The wire undergoing the filling step set forth above was subjected to drawing and rolling in the usual manner to achieve a short-length wire of 100 mm in length, 4.1 mm in width and 0.23 mm in thickness. Thus, a short-length wire of 100 mm in length, 4.1 mm in width and 0.23 mm in thickness with the silver ratio of 1.5 and 55 filaments was obtained.

The filament portion of the wire prior to the sintering step did not include the Bi-2223 phase in composition, and the Bi and Pb composition ratio was 0.177 corresponding to the atomic ratio represented by Pb/(Bi+Pb).

The wire obtained as described above was subjected to a sintering step under the conditions defined in Table 1 set forth below (provided that the gas component other than oxygen was nitrogen) to produce a superconducting wire of the present invention.

The critical current (Ic) of the superconducting wire thus produced was measured. The results are shown in Table 1. The critical current was measured by the 4-terminal method in liquid nitrogen (77K).

For Comparative Examples 1-4, raw material powder of the Examples set forth above was employed, provided that the powder was subjected to heat treatment in advance. Superconducting wires were produced in a manner similar to that of the above-described Examples, with the exception that an amount of the Bi-2223 phase (mass %) was included as defined in Table 1 set forth below for the composition of the filament portion in the wire prior to the sintering step, and the conditions defined in Table 1 were employed for the sintering step. The measured results of the critical current (Ic) of superconducting wires thus produced are also shown in Table 1.

**Table 1**

| No. | Presence of Bi-2223 Phase Prior to Sintering Step | Sintering Step Conditions | | | Critical Current (Ic) | Half-value Breadth |
|---|---|---|---|---|---|---|
| | | Oxygen Partial Pressure | Sintering Temperature | Sintering Duration | | |
| Example 1 | Not contained | 0.16 atm | 835°C | 70 hours | 34A | 17.1 |
| Example 2 | Not contained | 0.21 atm | 840°C | 70 hours | 38A | 16.3 |
| Example 3 | Not contained | 0.08 atm | 825°C | 50 hours | 30A | 17.5 |
| Comparative Example 1 | 6 mass % | 0.21 atm | 840°C | 70 hours | 16A | 19.0 |
| Comparative Example 2 | 10 mass % | 0.21 atm | 840°C | 70 hours | 20A | 19.0 |
| Comparative Example 3 | 20 mass % | 0.21 atm | 840°C | 70 hours | 22A | 20.1 |
| Comparative Example 4 | 20 mass % | 0.08 atm | 825°C | 50 hours | 19A | 21.8 |

It is appreciated from Table 1 that all the superconducting wires of Examples 1-3 had the critical current (Ic) improved as compared to the superconducting wires of Comparative Examples 1-4 (Comparative Examples 1-4 exhibited 16-22A, whereas Examples 1-3 exhibited 30-38A).

The orientation of the Bi-2223 phase crystal grains in the superconducting wires of Examples 1-3 and Comparative Examples 1-4 was identified by measuring the rocking curve through X-ray diffraction. The half-value breadth was as shown in Table 1. Since those with a smaller half-value breadth exhibited higher orientation, it is apparent that the superconducting wires of Examples 1-3 had the orientation of the Bi-2223 phase crystal grains improved as compared to those of Comparative Examples 1-4.

All these results indicate that a superconducting wire superior in superconducting property can be obtained by the absence of Bi-2223 phase in composition in the filament portion prior to the sintering step.

### <Examples 4-5 and Comparative Examples 5-6>

Superconducting wires of the present invention were additionally produced in a manner similar to that of Examples 1-3, provided that the Bi and Pb composition ratio was 0.155 corresponding to the atomic ratio represented by Pb/(Bi+Pb) in composition of the filament portion in the wire prior to the sintering step by adjusting the blend of the raw material powder (a blend of each powder of Bi₂O₃, PbO, SrCO₃, CaCO₃, CuO at the ratio (mass ratio) of 1.81:0.33:1.90:2.00:3.00). The employed conditions for the sintering step are as defined in Table 2 set forth below.

The critical current (Ic) of the superconducting wire thus produced was measured, likewise Examples 1-3. The results are shown in Table 2 set forth below.

For Comparative Examples 5-6, raw material powder of the Examples set forth above was employed, provided that the powder was subjected to heat treatment in advance. Superconducting wires were produced in a manner similar to that of the above-described Examples, with the exception that an amount of the Bi-2223 phase (mass %) was included as defined in Table 2 set forth below for the composition of the filament portion in the wire prior to the sintering step, and the conditions defined in Table 2 were employed for the sintering step. The measured results of the critical current (Ic) of superconducting wires thus produced are also shown in Table 2.

**Table 2**

| No. | Presence of Bi-2223 Phase Prior to Sintering Step | Sintering Step Conditions | | | Critical current (Ic) | Half-value Breadth |
|---|---|---|---|---|---|---|
| | | Oxygen Partial Pressure | Sintering Temperature | Sintering Duration | | |
| Example 4 | Not contained | 0.21 atm | 845°C | 70 hours | 36A | 16.8 |
| Example 5 | Not contained | 0.08 atm | 825°C | 50 hours | 27A | 17.4 |
| Comparative Example 5 | 20 mass % | 0.21 atm | 845°C | 70 hours | 20A | 19.7 |
| Comparative Example 6 | 20 mass % | 0.08 atm | 825°C | 50 hours | 18A | 23.7 |

It is appreciated from Table 2 that superconducting wires of Examples 4-5 had the critical current (Ic) improved as compared to that of the superconducting wires of Examples 5-6 (Comparative Examples 5-6 exhibited 18-20A, whereas Examples 4-5 exhibited 27-36A).

The orientation of the Bi-2223 phase crystal grains in the superconducting wires of Examples 4-5 and Comparative Examples 5-6 was identified by measuring the rocking curve through X-ray diffraction. The half-value breadth was as shown in Table 2. Since those with a smaller half-value breadth value exhibited higher orientation, it is apparent that the superconducting wires of Examples 4-5 had the orientation of the Bi-2223 phase crystal grains improved as compared to that of Comparative Examples 5-6.

All these results indicate that a superconducting wire superior in superconducting property can be obtained by the absence of Bi-2223 phase in composition of the filament portion prior to the sintering step.

### <Examples 6-7 and Comparative Examples 7-8>

Each of the superconducting wires produced according to Example 2, Example 4, Comparative Example 3, and Comparative Example 5 set forth above was further conducted to a second rolling step, followed by a second sintering step under the conditions defined in Table 3 set forth below. Results of critical current (Ic) measured in a manner similar to that described above for the produced superconducting wires undergoing such steps are shown in Table 3 set forth below.

The orientation of the Bi-2223 phase crystal for each of these superconducting wires was obtained by measuring the rocking curve through X-ray diffraction in a manner set forth above, and the half-value breadth is shown in Table 3.

**Table 3**

| No. | Second Sintering Step Conditions | | | Critical Current (Ic) | Half-value Breadth |
|---|---|---|---|---|---|
| | Oxygen Partial Pressure | Sintering Temperature | Sintering Duration | | |
| Example 6 | 0.08 atm | 820°C | 50 hours | 95A | 16.8 |
| Example 7 | 0.08 atm | 820°C | 50 hours | 98A | 16.7 |
| Comparative Example 7 | 0,08 atm | 820°C | 50 hours | 82A | 21.0 |
| Comparative Example 8 | 0.08 atm | 820°C | 50 hours | 83A | 20.4 |

Example 6, Example 7, Comparative Example 7 and Comparative Example 8 in Table 3 correspond to those using each of the superconducting wires produced by Example 2, Example 4, Comparative Example 3 and Comparative Example 5, respectively.

It is appreciated from Table 3 that all the superconducting wires of Examples 6-7 had the critical current (Ic) improved than that of the superconducting wires of Comparative Examples 7-8 (Comparative Examples 7-8 exhibited 82-83A, whereas Examples 6-7 exhibited 95-98A).

The values of the half-value breadth indicate that the superconducting wires of Examples 6-7 have the orientation of the Bi-2223 phase crystals improved than that of Comparative Examples 7-8.

All these results indicate that, by virtue of the absence of the Bi-2223 phase in composition of the filament portion prior to the first sintering step, a superconducting wire superior in superconducting property was obtained even after execution of the second rolling step and second sintering step.

### <Examples 8-9>

Superconducting wires were produced in a manner similar to that of the superconducting wires of Examples 6 and 7 set forth above, provided that the condition of 70 hours for the sintering duration in the first sintering step was altered to the condition of 50 hours, that is shorter in time (the superconducting wire of Example 8 corresponds to the superconducting wire of Example 6, and the superconducting wire of Example 9 corresponds to the superconducting wire of Example 7).

The critical current (Ic) was measured in a manner similar to that described above for these superconducting wires. The superconducting wire of Example 8 exhibited 98A, whereas the superconducting wire of Example 9 exhibited 118A. They exhibit superconducting properties further superior to those of the superconducting wires of Examples 6 and 7.

The half-value breadth was also measured in a similar manner. The superconducting wire of Example 8 exhibited 16.6 whereas the superconducting wire of Example 9 exhibited 16.5. They indicated further improvement in the Bi-2223 phase crystal orientation than that of the superconducting wires of Examples 6 and 7.

It should be understood that the embodiments and examples disclosed herein are illustrative and non-restrictive in every respect. The scope of the present invention is defined by the terms of the claims, rather than the description above, and is intended to include any modification within the scope and meaning equivalent to the terms of the claims.

## Claims

1. A method for producing a superconducting wire (1) including a filament portion (2) which contains a Bi-2223 phase and a sheath portion (3) covering the filament portion, said method including a filling step, a drawing step, a rolling step, and a sintering step,
wherein said filament portion (2) is absent of the Bi-2223 phase in composition prior to said sintering step.

2. The method for producing a superconducting wire according to claim 1, wherein said sintering step is executed under conditions of at least 0.03 atm and not more than 0.21 atm in oxygen partial pressure, at least 810°C and not more than 850°C in sintering temperature, and at least 20 hours and not more than 100 hours in sintering duration.

3. The method for producing a superconducting wire according to claim 1, wherein said filament portion (2) has a composition ratio ofBi and Pb that is at least 0.14 and not more than 0.18 corresponding to an atomic ratio represented by Pb/(Bi+Pb) in composition prior to said sintering step.

4. The method for producing a superconducting wire according to claim 1, wherein said sintering step is carried out at least two times in said method, and said filament portion (2) is absent of the Bi-2223 phase in composition prior to a first sintering step among said sintering steps carried out at least two times.

5. The superconducting wire (1) produced by the method for producing a superconducting wire defined in claim 1.

6. A superconductive apparatus, wherein the superconducting wire (1) defined in claim 5 is used.
